# EUROPÄISCHE PATENTSCHRIFT

(11) **EP 1 368 974 B1**
(45) Veröffentlichungstag und Bekanntmachung des Hinweises auf die Patenterteilung: **13.10.2004**
(21) Anmeldenummer: 02729935.3
(22) Anmeldetag: 25.02.2002
(51) Int. Cl.: H04N 17/04

(54) **VERFAHREN UND PRÜFVORRICHTUNG ZUR PRÜFUNG DER ELEKTROMAGNETISCHEN VERTRÄGLICHKEIT VON BILDSCHIRMGERÄTEN**
METHOD AND DEVICE FOR TESTING THE ELECTROMAGNETIC COMPATIBILITY OF SCREEN DEVICES
PROCEDE ET DISPOSITIF DE CONTROLE PERMETTANT DE CONTROLER LA COMPATIBILITE ELECTROMAGNETIQUE D'APPAREILS D'AFFICHAGE VIDEO

(30) Priorität: 15.03.2001 DE 10112528
(43) Veröffentlichungstag der Anmeldung: 10.12.2003
(73) Patentinhaber: Rohde & Schwarz GmbH & Co. KG, 81671 München (DE)
(72) Erfinder: MEDLER, Jens, 82178 Puchheim (DE); MASCHOTTA, Peter, 98673 Eisfeld OT Harras (DE)
(74) Vertreter: Körfer, Thomas, Dipl.-Phys.
(86) Internationale Anmeldenummer: PCT/EP2002/001968
(87) Internationale Veröffentlichungsnummer: WO 2002/076108

(56) Entgegenhaltungen:
- EP-A- 0 247 627
- EP-A- 0 716 312
- EP-A- 0 924 939
- US-A- 5 448 502
- US-A- 5 572 444

## Beschreibung

Die Erfindung betrifft ein Verfahren zur Feststellung der elektromagnetischen Verträglichkeit von Bildschirmgeräten, sowie ein System zu dessen Anwendung.

Die Prüfung der elektromagnetischen Verträglichkeit von Bildschirmgeräten erfolgt üblicherweise durch Testpersonen. Die Testpersonen beobachten zur Überprüfung eine Bildschirmdarstellung eines Prüflings, wobei die Bildschirmdarstellung im ungestörten Fall ein Testbild ist, das aus parallelen Farbbalken besteht. Zur Feststellung der elektromagnetischen Verträglichkeit wird der Prüfling zusätzlich zu dem Signal des Testbilds mit einem Störsignal beaufschlagt, das auf verschiedene Arten eingekoppelt sein kann. Dabei ist die Einkopplung ebenso auf dem Signalweg des Testbilds möglich, wie beispielsweise über das Stromnetz.

Eine Störung des Testbildes durch ein eingekoppeltes Störsignal wird durch die Testperson erkannt und vermerkt. Das Störsignal wird durch einen Prüfgenerator erzeugt, der auch das Signal für das Testbild an den Prüfling übermittelt. Die Prüfung wird über eine Vielzahl von Frequenzen für das Störsignal wiederholt.

Nachteilig bei dem dargestellten Prüfverfahren ist die subjektive Beurteilung durch eine oder mehrere Testpersonen. Insbesondere durch die vielfache Wiederholung des Test mit verschiedenen Frequenzen und Pegeln des Störsignals ist von einem Nachlassen des Konzentrationsvermögens auszugehen. In umfangreichen Versuchen muß daher eine sogenannte Falschakzeptanzrate ermittelt werden, die eine Abschätzung der falsch erkannten oder nicht erkannten Störungen angibt.

Insbesondere ist die subjektive Beurteilung starken Schwankungen unterworfen, so daß derselbe Prüfling in unterschiedlichen Testreihen unterschiedliche Ergebnisse liefern kann. Abgesicherte Beurteilungen sind deshalb nur über statistische Absicherung der Ergebnisse möglich. Durch den Einsatz von Testpersonen führt dies jedoch zu einem deutlichen Anstieg der Kosten, die mit einer Prüfung verbunden sind.

Das vorveröffentlichte Dokument US-A-5,448,502 zeigt eine statistische Auswertung zur Beurteilung der Bildqualität.

Der Erfindung liegt die Aufgabe zugrunde, ein Prüfverfahren und eine Prüfvorrichtung zu dessen Anwendung zur Überprüfung der elektromagnetischen Verträglichkeit von Bildschirmgeräten zu schaffen, das eine objektive Bewertung ermöglicht und eine hohe Reproduzierbarkeit sicherstellt.

Die Aufgabe wird durch das erfindungsgemäße Verfahren und die erfindungsgemäße Prüfvorrichtung mit den Merkmalen nach Anspruch 1 bzw. 12 gelöst.

Zur Beurteilung eines Störeinflusses von Störsignalen auf die Bilddarstellung eines Testbilds wird im einfachsten Fall segmentweise ein mittlerer Signalwert gebildet. Die Abweichung des Mittelwerts des Signals eines solchen Segments von einer bei ungestörtem Bild ermittelten Bezugsgröße bildet die Entscheidungsgrundlage dafür, ob ein Störeinfluß vorliegt. Um eine Störung sicher detektieren zu können wird das Testfenster in vorzugsweise festen Winkelinkrementen gedreht und für mehrere Winkel eine Auswertung durchgeführt, wodurch für bestimmte Winkel einer z.B. streifenförmigen Störung eine Messung mit näherungesweise parallel dazu ausgerichteten Segmenten durchgeführt wird. Die Entscheidung ob ein Bild störungsfrei ist oder nicht unterliegt damit nicht mehr einer Testperson und ist reproduzierbar. Das Verfahren liefert für einen Prüfling unabhängig vom jeweiligen Prüf- oder Testpersonal ein wiederholbares Ergebnis und erhöht damit die Vergleichbarkeit verschiedener Versuchsreihen.

Durch die in den Unteransprüchen aufgeführten Maßnahmen sind vorteilhafte Weiterbildungen des erfindungsgemäßen Verfahrens und des erfindungsgemäßen Systems möglich.

Die Konvertierung des Testbilds in einen geeigneten Farbraum, vorzugsweise Grau, sorgt für gut zu verarbeitende Werte. Dabei kann sowohl die vollständige Bildinformation in ein Grauwertbild konvertiert werden als auch ein Ausschnitt des Testbilds der herausgegriffen wird und Grundlage des weiteren Auswerteverfahrens ist.

Die Drehung des Testfensters um ein vorgegebenes Winkelinkrement wird so oft wiederholt, bis eine Gesamtdrehung des Testfensters um 180° erreicht ist. Bei streifenförmigen Störbildern ist dadurch für jeden Winkel gewährleistet, daß die Segmente des Testfensters bei einer der Messungen näherungsweise parallel zu den Störstreifen ausgerichtet sind und damit eine signifikante Abweichung der Mittelwerte auftritt.

Ein weiterer Vorteil ist die einfache Vergleichsmöglichkeit der Varianzen der Abweichungen durch eine grafische Darstellung. Werden dabei die Varianzen der Abweichungen als Funktion des Drehwinkels aufgetragen, so kommt es bei Übereinstimmung des Winkels des Testfensters mit der Orientierung der Störerscheinung zur Ausbildung eines Peaks in der grafischen Darstellung, der leicht erkennbar ist.

Bei der Auswahl der Größe und Positionierung des Testfensters ist die Testfensterdiagnonale so bemessen, daß bei beliebiger Drehung des Testfensters stets alle Bildpunkte, die innerhalb des Testfensters liegen, zu demselben Farbbalken des Testbilds gehören. Damit wird der Einfluß einer Farbbalkengrenze des Testbilds, das aus verschiedenen Farbbalken aufgebaut ist, ausgeschlossen.

Zusätzlich wird die Ausgangslage des Testfensters nach einer Drehung um 180° um ein Längeninkrement parallel zu einer Grenze eines Farbbalkens in Richtung des Farbbalkenendes verschoben und in dieser neuen Ausgangslage die Drehung des Testfensters wiederholt. Bei Störmustern, in denen der Streifenabstand sehr groß ist, kann auch bei verhältnismäßig kleinen Testfenster somit sichergestellt werden, daß eine korrekte Erfassung des Störmusters durchgeführt wird. Die stückweise Verschiebung des Testfensters entlang eines Farbbalkens stellt nahezu ein Abdecken des vollständigen Testbilds sicher.

Für verschiedene Farbbalken wird der Ablauf wiederholt. Da die Störmuster in verschiedenen Farbbalken unterschiedliche Ausprägungen haben können, wird vermieden, das innerhalb eines Farbbalkens ein Prüfling als "gut" bewertet wird, der in anderen Farbbalken signifikante Störerscheinungen aufweist. Die Untersuchungen werden für Störsignale verschiedener Amplituden und Frequenzen durchgeführt.

Durch ein Prüfvorrichtung, bei dem eine Recheneinheit die Steuerung eines Prüfgenerators übernimmt und zudem die Bildinformation verarbeitet, ist eine zeitlich optimale Abstimmung der einzelnen Verfahrensschritte möglich. Von besonderem Vorteil ist die Möglichkeit sowohl direkt als auch indirekt eine Bildinformation zu gewinnen, anhand dessen die Auswertung durchgeführt wird. Dazu ist entweder eine Camera mit der Recheneinheit verbunden oder die Bildinformation wird direkt vom Prüfling an die Recheneinheit übermittelt. Beispielsweise ist eine Video-out Buchse des Bildschirmgeräts verwendbar.

Bei Verwendung einer CCD-Camera wird die Prüfvorrichtung in einem Dunkelraum angeordnet, um Meßfehler, die durch Streulicht oder Reflexionen auftreten können, auszuschließen. Die Anordnung von CCD-Camera und Bildschirmgerät direkt gegenüber, mit einem Tubus auf seiten der Camera, ermöglicht die Begrenzung des Aufnahmewinkels auf ausschließlich das Bildschirmbild.

Durch die Integration eines Co-Prozessors vorzugsweise bestehend aus DSP und/oder FPGA in der Recheneinheit ist die Rechenzeit für einen Auswertevorgang vorteilhaft verkürzt.

Die Berechnung der Bezugsgröße aus dem ungestörten Testbild erfolgt vorzugsweise für eine fest eingestellte Bildhelligkeit und eine definierte Bildschärfe, so daß reproduzierbare Testverhältnisse gewährleistet sind und darüber hinaus ein Einfluß von Moirebildung und Bildschirmmaskenstruktur, die durch optische Komponenten bedingt sind, keinen signifikanten Einfluß haben.

Das erfindungsgemäße Verfahren und das System zur Überprüfung der elektromagnetischen Verträglichkeit sind in den Zeichnungen schematisch dargestellt und werden in der nachfolgenden Beschreibung näher erläutert. Es zeigen:
- Fig. 1: eine schematische Darstellung eines ersten Ausführungsbeispiels eines erfindungsgemäßen Systems;
- Fig. 2: eine schematische Darstellung eines zweiten Ausführungsbeispiels eines erfindungsgemäßen Systems;
- Fig. 3: eine schematische Darstellung des Aufbaus eines Testbilds mit einem Testfensters in Ausgangslage;
- Fig. 4: eine schematische Darstellung der Orientierung des Testfensters für verschiedene Zeitpunkte des erfindungsgemäßen Verfahrens;
- Fig. 5: ein Flußdiagramm des erfindungsgemäßen Verfahrens;
- Fig. 6: eine schematische Darstellung zur Erläuterung der Wirkungsweise der Erfindung; und
- Fig. 7: Verlauf einer mittleren Bezugsgröße in Abhängigkeit von einem die Bildschärfe beeinflussenden Parameters.

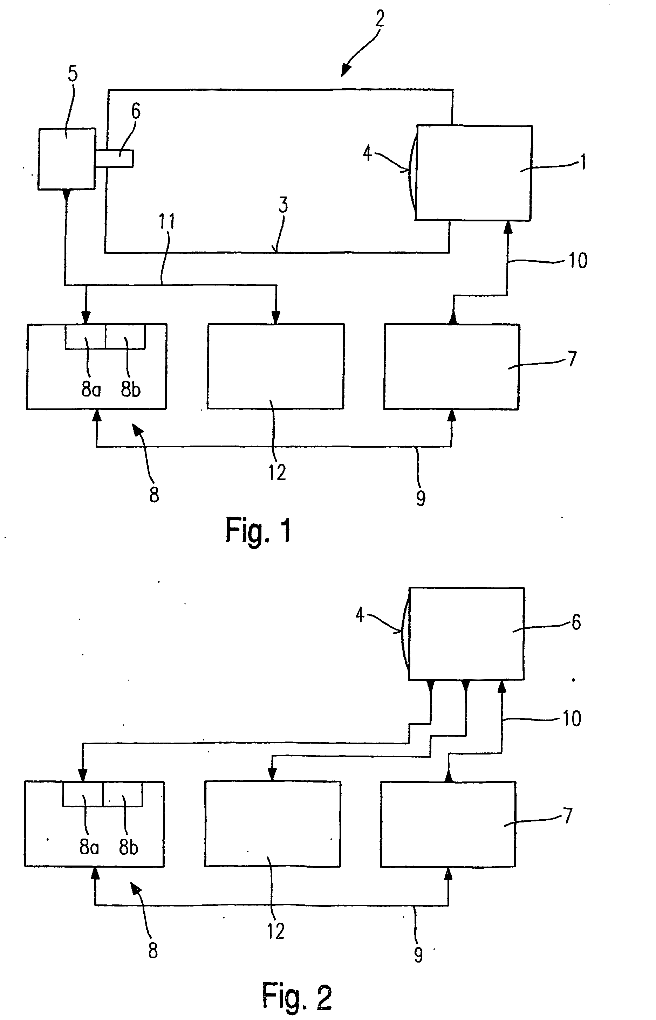

In Fig. 1 ist ein erstes Ausführungsbeispiel einer erfindungsgemäßen Prüfvorrichtung zur Überprüfung der elektromagnetischen Verträglichkeit eines Bildschirmgeräts dargestellt. Ein Prüfling 1 ist in einem Dunkelraum 2 angeordnet, so daß zumindest die Bildschirmfläche 4 in einen Ausschnitt des Dunkelraums 2 hineinragt. Gegenüber der Bildschirmfläche 4 ist, mit einem Objektiv auf die Bildschirmfläche 4 gerichtet, eine CCD-Camera 5 angeordnet. Zur Vermeidung von Fehlern in der Bildauswertung ist das Objektiv der CCD-Camera 5 in einem Tubus 6 angeordnet, so daß ausschließlich direktes Licht der Bildschirmfläche 4 von der CCD-Camera 6 detektiert wird. Zudem sind die Innenwände 3 des Dunkelraums 2 zur Vermeidung von Reflexionen geschwärzt.

Der Prüfling 1, zum Beispiel ein Fernsehgerät oder ein Computermonitor, ist mit seinem Signaleingang mit einem Prüfsystem 7 verbunden. In dem Prüfsystem 7 wird ein Testbildsignal erzeugt, das über eine Signalverbindungsleitung 10 an den Prüfling 1 übertragen wird. Zusätzlich wird durch das Prüfsystem 7 ein Störsignal generiert, dessen Frequenz und Amplitude einstellbar sind.

Das Prüfsystem 7 ist mit einer Steuerleitung 9 mit einer Recheneinheit 8 verbunden. Die Information über die einzustellende Amplitude und Frequenz des einzustreuenden Störsignals ist über die Steuerleitung 9 von der Recheneinheit 8 aus an das Prüfsystem 7 übertragbar.

Die CCD-Camera 5 ist mit einem Eingang 8a der Recheneinheit 8 verbunden, so daß die Bildinformation, die durch Aufnahme der Bildschirmfläche 4 von der CCD-Camera 5 gewonnen wird, in der Recheneinheit 8 verarbeitet werden kann. Zur Verbesserung der Rechenleistung kann ein Co-Prozessor auf einer Steckkarte 8b in der Recheneinheit 8 angeordnet sein. Zudem ist ein Monitor 12 mit dem Ausgang der CCD-Camera 5 verbunden, um das Ergebnis der Aufnahme der CCD-Camera 5 darstellen zu können.

Fig. 2 zeigt ein zweites Ausführungsbeispiel einer erfindungsgemäßen Prüfvorrichtung. Dabei wird die Bildinformation direkt durch einen Ausgang des Prüflings 1 an den Eingang 8a der Recheneinheit 8 geleitet. Hierzu kann beispielsweise eine Video-out Buchse des Prüflings 1 verwendet werden. Das in der Recheneinheit 8 ankommende Signal des Videoausgangs enthält alle Bildinformationen die dem Prüfling 1 selbst ebenfalls zum Bildaufbau verfügbar sind.

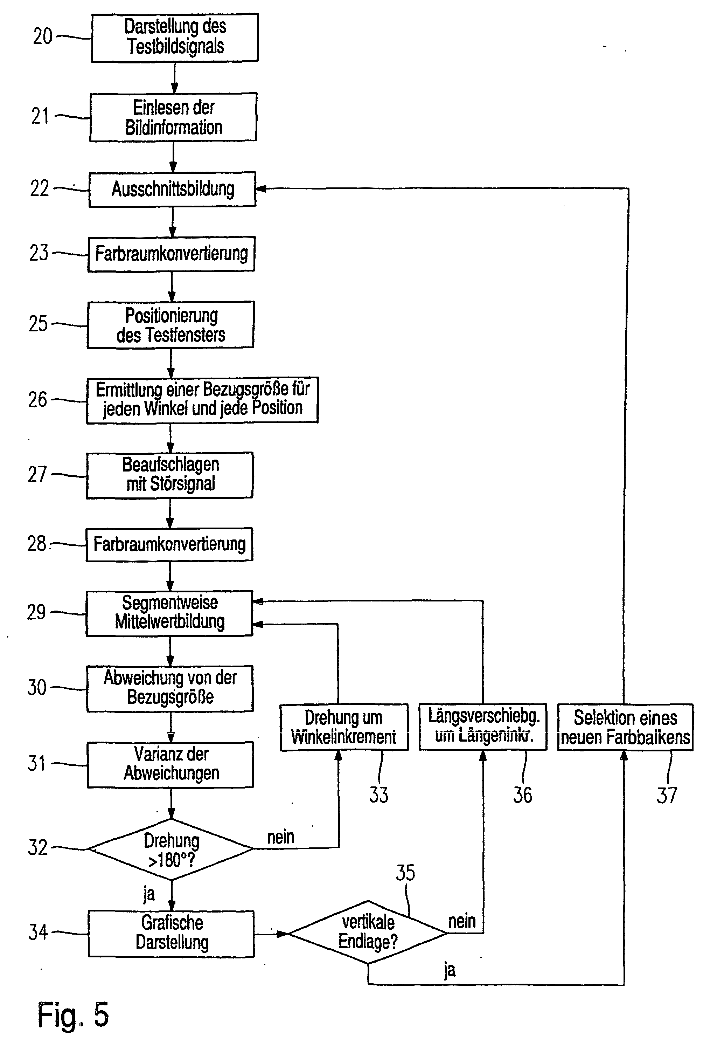

Zur Visualisierung des Bildes wird ein Monitor 12 verwendet, der mit dem Prüfling 1 verbunden ist. Die Weiterverarbeitung der Bildinformation wird in der Beschreibung zu Fig. 5 detailliert erläutert und erfolgt für beide Systeme identisch.

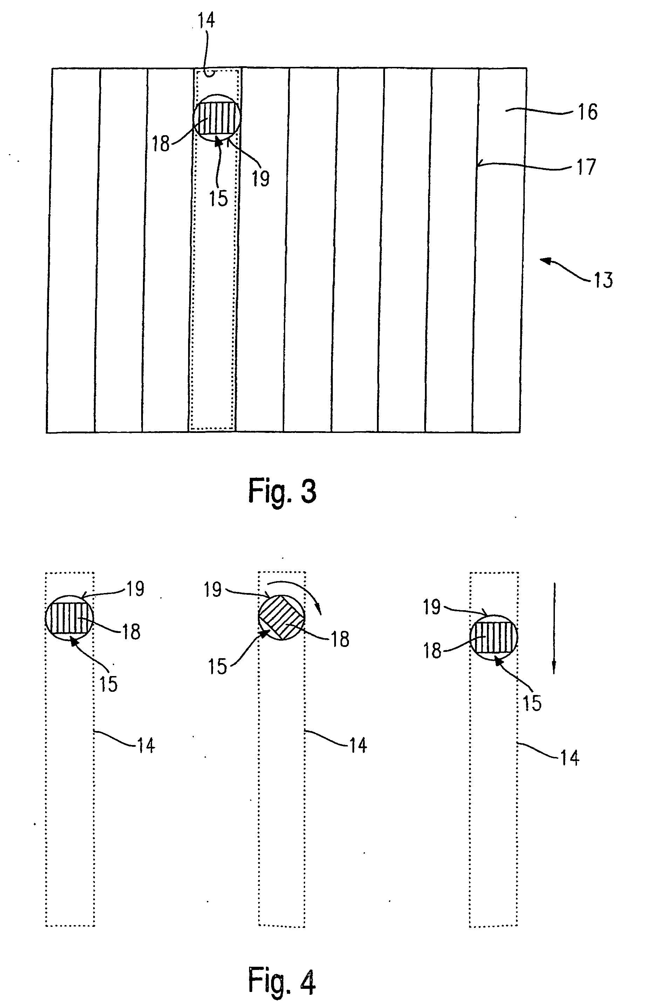

In Fig. 3 ist der Aufbau eines Testbilds 13, eines Ausschnitts 14 und eines zur Auswertung verwendeten Testfensters 15 schematisch dargestellt. Das Testbild 15 besteht aus mehreren Farbbalken 16, an deren Übergang eine gerade Linie als Farbgrenze 17 ausgebildet ist.

Innerhalb eines Farbbalkens 16 wird aus dem Testbild 13 ein Ausschnitt 14 herausgegriffen, in dem das Testfenster 15 positioniert wird. Das Testfenster 15 weist die Form eines Rechtecks, vorzugsweise eines Quadrats auf, dessen Diagonale höchstens identisch ist mit der Breite des Ausschnitts 14 der innerhalb eines einzelnen Farbbalkens 16 angeordnet ist. Das Testfenster 15 ist vorzugsweise so in einem Farbbalken 16 positioniert, daß der Schnittpunkt der beiden Diagonalen auf der Mittellinie eines Farbbalkens 16 liegt.

Innerhalb eines Testfensters 15 sind mehrere Segmente 18 ausgebildet. Die Segmente 18 sind parallel zu einer Seitenlinie des rechtwinkligen Testfensters 15 orientiert und selbst wiederum rechteckige Flächen.

In Fig. 4 sind neben der Ausgangslage des Testfensters 15 zwei weitere Positionen des Testfensters 15 gezeigt, die bei der Durchführung des Auswerteverfahrens von dem Testfenster 15 eingenommen werden.

Als Ausgangslage ist das Testfenster 15 so in einem der Farbbalken 16 des Testbilds 15 positioniert, daß die Segmente 18 parallel zu den Farbgrenze 17 der Farbbalken 16 verlaufen. Um die unter verschiedenen Winkeln zu den Farbgrenzen 17 verlaufenden linienförmigen Störungen erkennen zu können, wird das Testfenster 15 um den Schnittpunkt seiner Diagonalen gedreht. Dabei ist vorzugsweise ein Winkelinkrement im Bereich von zwei Grad zu wählen. Die Lage des Schnittpunkts der beiden Diagonalen bleibt dabei zunächst unverändert. Die Eckpunkte des Testfensters 15 beschreiben bei der Drehung einen Kreis 19, dessen Fläche vollständig innerhalb eines Farbbalkens 16 liegt. Für jede Winkelposition des Testfensters 15 wird eine Auswertung der Bildinformation vorgenommen. Die Auswertung der Bildinformation wird anhand von Fig. 5 ausführlich beschrieben. Die Drehung des Testfensters 15 um ein Winkelinkrement wird so lange fortgesetzt, bis das Testfenster 15 eine Drehung von 180° bezüglich seiner Ausgangslage erreicht hat.

Bei einer Drehung von 180° bezüglich der Ausgangslage ist in den meisten Fällen ein ausreichender Informationsgehalt gewährleistet. Der Mittelpunkt des Testfensters 15 wird anschließend zu einer neuen Position hin verschoben. Die vorstehende Drehung des Testfensters 15 wird um den neuen Mittelpunkt wiederholt, bis wiederum eine Drehung von 180° erreicht ist. Das Verschieben des Testfensters 15 erfolgt parallel zu den Farbgrenzen 17. Dabei wird vorzugsweise ein konstantes Längeninkrement verwendet, um das die Verschiebung durchgeführt wird. Damit wird die gesamte Länge eines Farbbalkens 16 durch die Auswertung erfaßt.

In Fig. 5 ist der Ablauf des Verfahrens schematisch dargestellt. Zu Beginn des Verfahrens wird dem Prüfling 1 von dem Prüfsystem 7 ein Testbildsignal 20 übermittelt. Das darzustellende Testbild entspricht vorzugsweise der CCIR-Empfehlung 471. Auf dem Prüfling 1 wird ein dem Testbildsignal entsprechendes Bild dargestellt. Durch die Recheneinheit 8 erfolgt das Einlesen der Bildinformation 21. Dazu wird entweder direkt ein Ausgang des Prüflings 1 verwendet oder die Bildschirmdarstellung des Prüflings 1 mit einer CCD-Camera 5 aufgenommen. Die Bildinformation wird in beiden Fällen mittels Kabel an den Eingang 8a der Recheneinheit 8 übertragen. Zur Weiterverarbeitung wird im Ausführungsbeispiel eine Auflösung von 640x480 Pixel verwendet. Die Recheneinheit 8 ist ein PC, wobei die Rechenleistung durch die Verwendung der Steckkarte 8b mit einem Co-Prozessor, der als FPGA mit DSP ausgeführt ist, verbessert wird. Die Rechnungen zur Auswertung erfolgen auf der zusätzlichen Steckkarte 8b und der Hauptprozessor des PC's wird entlastet.

Aus den eingelesenen Bildinformationen wird durch eine Ausschnittsbildung 22 ein Teil der Bildinformation herausgegriffen, der einem Farbbalken 16 des Testbilds entspricht. Für den Ausschnitt erfolgt eine Farbraumkonvertierung 23, vorzugsweise Grauwertkonvertierung, der Darstellung des Testbilds, das in 24bit RGB Farben dargestellt ist, in 8bit Grauwerte. Bedingt durch die Breite der Farbbalken 16 ist die Breite eines Ausschnitts 14 auf maximal 80 Pixel begrenzt, so daß innerhalb eines Ausschnitts 14 keine Farbgrenze 17 vorhanden ist. Als Höhe wird der gesamte vertikale Ausdehnung des Farbbalkens 16 von 480 Pixeln verwendet.

In dem nun in Grauwerten vorliegenden Ausschnitt 14 wird eine Positionierung 25 des Testfensters 15 durchgeführt, welches aus mehreren parallelen, rechteckigen Segmenten 18 aufgebaut ist. Die Positionierung erfolgt so, daß das Testfenster 15 bezüglich der Schmalseite des Ausschnitts 14 mittig und in Längsrichtung an einem Ende des Ausschnitts 14 angeordnet ist. Die Segmente 18 sind bei der zunächst einzunehmenden Ausgangslage des Testfensters 15 mit ihrer Längsseite parallel zur Längsseite des Ausschnitts 14 orientiert. Beginnend mit dieser Ausgangslage wird eine Referenzmessung durchgeführt, die der Ermittlung einer Bezugsgröße 26 für die spätere Auswertung dient. Als Referenzmessung wird aus den Grauwerten, die in Ausgangslage des Testfensters 15 innerhalb jeweils eines Segments 18 liegen, jeweils ein Mittelwert für jedes der Segmente 18 gebildet. Die weitere Mittelung der mittleren Grauwerte für jedes Segment 18 ist eine einfache Möglichkeit eine Bezugsgröße zu bestimmen. Vorzugsweise wird die Referenzmessung jedoch für jedes Winkelinkrement der späteren Messung und jede Position des Testfensters 15 bei der späteren Messung wiederholt. Anschließend wird eine Regressionsfunktion über alle Segmente 18 für jeden Winkel und jede Position des Testfensters 15 berechnet.

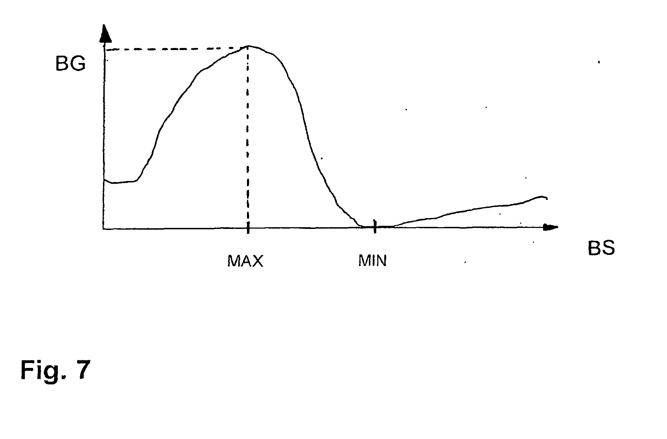

Die Berechnung der Bezugsgröße aus dem ungestörten Testbild erfolgt vorzugsweise für eine fest eingestellte Bildhelligkeit und bei einer definierten Einstellung für die Bildschärfe. Die Bildhelligkeit wird dazu so eingestellt, daß eine Übersteuerung des Videosignals sicher verhindert wird. Die Bildschärfe wird so gewählt, daß die durch optische Komponenten bedingte Moirébildung bzw. die Bildschirmmaskenstruktur keinen signifikanten Einfluß auf die zu berechnenden Abweichungen haben. Die Bildschärfe wird zur Einstellung mittels eines geeigneten Geräteparameters BS variiert. Bei der Variation des Bildschärfeparameters ändert sich die Bezugsgröße, so daß sich für die Bezugsgröße beispielsweise der in Fig. 7 dargestellte Verlauf ergibt. Die Bildschärfe wird nun durch denjenigen Parameterwert eingestellt, bei dem der Verlauf der Bezugsgröße BG nach einem globalen Maximum MAX ein Minimum MIN aufweist.

Nachdem die Bezugsgröße definiert ist, erfolgt das Beaufschlagen 27 des Prüflings 1 mit einem ebenfalls durch das Prüfsystem 7 erzeugten Störsignal. Für die bei Auftreten von Störungen veränderte Bildinformation wird für den Ausschnitt 14 erneut eine Farbraumkonvertierung 28 analog zur Referenzmessung, z. B. als eine Grauwertkonvertierung, durchgeführt.

Durch eine segmentweise Mittelwertbildung 29 wird für jedes Segment 18 des Testfensters 15 genau ein Wert, z. B. Grauwert, ermittelt. Für die so ermittelten Mittelwerte der einzelnen Segmente 18 wird die Abweichung von der Bezugsgröße 30 berechnet. Um alle Störmuster, die linienförmig sind erfassen zu können, wird hierzu eine vorzeichenfreie Größe verwendet, beispielsweise das Quadrat der Differenz des Mittelwerts von der Bezugsgröße. Als Entscheidungskriterium für eine auftretende Störung wird die Varianz der Abweichungen 31 ermittelt, so daß sich für das gesamte Testfenster 15 für jede Position und Orientierung genau ein Wert ergibt.

Nach abgeschlossener Berechnung der Varianz der Abweichungen wird ermittelt, ob das Testfenster 15 gegenüber seiner Ausgangslage bereits eine Drehung um 180° erreicht hat. Ist die Drehung um 180° noch nicht erreicht, erfolgt eine Drehung um ein vorbestimmtes Winkelinkrement 33, z.B. zwei Grad, und die segmenteweise Mittelwertbildung 29 und Berechnung der Abweichungen 30 wird ebenso wie die Berechnung der Varianz der Abweichungen 31 wiederholt. Für jeden neuen Winkel des Testfensters 15 und damit für jede neue Ausrichtung der Segmente 18 ergibt sich somit genau ein Wert für die Varianz der Abweichungen. Ist in einer Orientierung des Testfensters 15 die Ausrichtung der Segmente parallel zu einer Störung, so führen die veränderten Werte (Grauwerte) zu einer signifikanten Erhöhung der Varianz der Abweichungen. Dabei ist durch die Bildung der quadratischen Abweichungen und eine geeignete Normierung eine eindeutige Zuordnung zu den linienförmigen Störmustern sichergestellt.

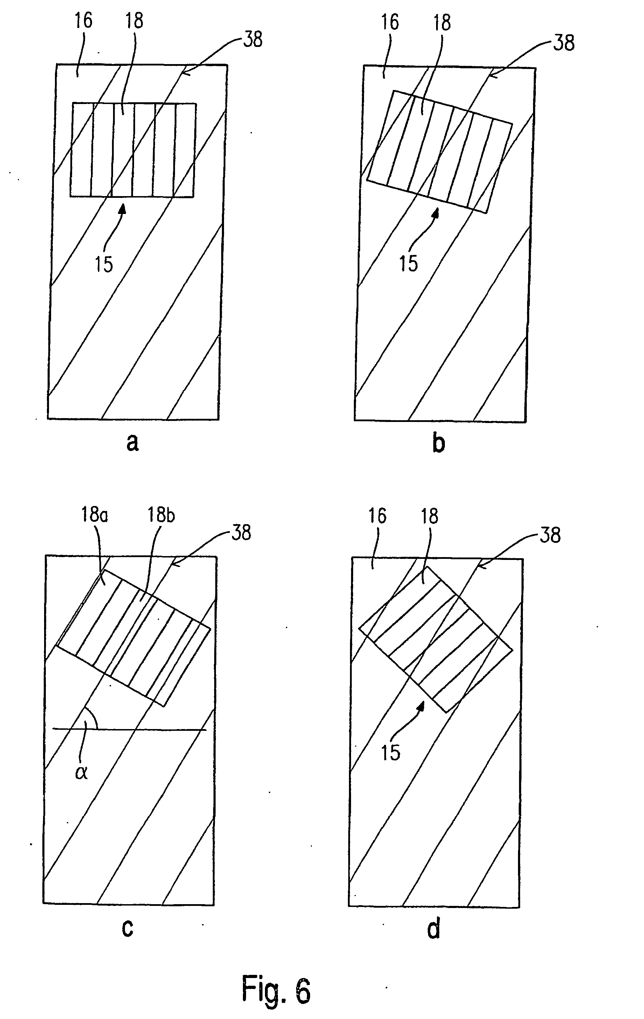

Anhand von Fig. 6 wird die Drehung des Testfensters 15 noch einmal veranschaulicht und ihre Wirkung beim Auftreten eines Störmusters erläutert. In dem Farbbalken 16 ist ein Störmuster mit parallelen Störstreifen 38 ausgebildet, das einen Winkel α mit dem Farbbalken 16 einschließt. Während in den Teilbildern a, b und d von Fig. 6 die Störstreifen 38 durch mehrere Segmente 18 verlaufen und damit den Mittelwert des Signals in den einzelnen Segmenten 18 nur geringfügig beeinflussen, da ein Großteil der Fläche des jeweiligen Segments 18 störungsfrei ist und ebenso zur Mittelwertbildung beiträgt, ist in Teilbild c von Fig. 6 das Testfenster 15 so orientiert, daß die Störstreifen 38 parallel zu den Segmenten verlaufen. Dadurch entstehen Segmente 18a, die durch das Störmuster nicht beeinflußt werden und Segmente 18b, deren Fläche einen sehr hohen Anteil des Störstreifens 38 aufweist und deren Mittelwert daher stark von den Mittelwerten der Segmente 18a abweicht. Die Varianz der Abweichungen für ein Testfenster 15, dessen Segmente 18 parallel zu den Störstreifen 38 ausgerichtet sind, erhöht sich signifikant.

Ist die Drehung des Testfensters von 180° nach Berechnen der Varianz der Abweichungen 31 erreicht, werden die Varianzen der Abweichungen als grafische Darstellung 34 ausgegeben. Die Varianz der Abweichungen wird über dem Drehwinkel aufgetragen. Ist ein linienförmiges Störmuster vorhanden, so ergeben sich für den Drehwinkel, bei dem die Orientierung des Testfensters mit seinen Segmenten 18 mit der Richtung der Störstreifen identisch ist, Peaks in der aufgetragenen Varianz der Abweichungen.

In einem nächsten Verfahrensschritt wird ermittelt, ob die Lage des Testfensters 15 innerhalb des Ausschnitts 14 am gegenüberliegenden Ende der ursprünglichen Position angelangt ist. Ist das Testfenster 15 noch nicht an dem gegenüberliegenden Ende angelangt, erfolgt eine Längsverschiebung 36 des Testfensters 15 um ein festes Längeninkrement. Die Auswertung der Bildinformation erfolgt wiederum entsprechend den Verfahrensschritten 29 und folgende. Bei Erreichen des gegenüberliegenden Endes des Ausschnitts 14 ist die Auswertung eines Farbbalkens 16 beendet. Danach oder schon parallel dazu kann eine neue Ausschnittsbildung innerhalb eines anderen Farbbalkens 16 des Testbilds erfolgen.

Die Verfahrensschritte sind für die Auswertung für eine einzelne Störfrequenz dargestellt. Für die Prüfung der elektromagnetischen Verträglichkeit kann der Prüfling z.B. gemäß der EN 55020 mit einem Störsignal beaufschlagtwerden. Die Auswertung erfolgt für die einzelnen Einkopplungsarten des Störsignals und die verschiedenen Frequenzpunkte wiederholt.

Das erfindungsgemäße Verfahren eignet sich auch zur Erkennung von Störungen bei digitalen Bildübertragungsverfahren, z. B. MPEG. Dort sind die Störungen durch Ausfall von Makroblöcken (z. B. 8 x 8 Pixel) und/oder Bewegungsartefakte gekennzeichnet, so daß an den Kanten der ausgefallenen Makroblöcke Linienstörungen entstehen, die wie vorstehend beschrieben detektiert werden können. Dabei ist die Größe des Testfensters 15 und die Farbraumkonvertierung entsprechend anzupassen. Ggf. ist eine Vorfilterung des Bildes durchzuführen.

## Patentansprüche

1. Verfahren zur Prüfung der elektromagnetischen Verträglichkeit von Bildschirmgeräten, die ein Signal für ein Testbild von einem Prüfgenerator (7) erhalten, durch den ein Prüfling (1) zusätzlich zu einem Testbildsignal mit einem Störsignal beaufschlagbar ist, mit folgenden Verfahrensschritten:
- Unterteilen der Bildinformation eines Testfensters (15) in mehrere parallele Segmente (18);
- Ermitteln einer Bezugsgröße aus einem störungsfreien Testbild (13) in dem Testfenster (15);
- Bilden des Mittelwerts des Signals jedes Segments (18);
- Berechnen der Abweichung des Mittelwerts jedes einzelnen Segments (18) von der Bezugsgröße;
- Berechnen der Varianz der Abweichungen aller Segmente (18) des Testfensters (15);
- Wiederholen der Berechnung der Varianz der Abweichungen für mehrere, jeweils um ein Winkelinkrement gedrehte Testfenster (15); und
- Vergleichen der für die einzelnen Drehwinkel des Testfensters (15) berechneten Varianzen der Abweichungen.

2. Verfahren nach Anspruch 1,
**dadurch gekennzeichnet,**
**daß** die Bildinformation des Testbilds (13) in ein Grauwertbild konvertiert wird.

3. Verfahren nach Anspruch 1,
**dadurch gekennzeichnet,**
**daß** das Verfahren für einen Ausschnitt (14) des Testbilds (13) durchgeführt wird, innerhalb dessen das Testfenster (15) positioniert ist.

4. Verfahren nach Anspruch 3,
**dadurch gekennzeichnet,**
**daß** die Bildinformation des Ausschnitts (14) in ein Grauwertbild konvertiert wird.

5. Verfahren nach einem der Ansprüche 1 bis 4,
**dadurch gekennzeichnet,**
**daß** die Varianz als Mittelwert der quadratischen Abweichung von der Bezugsgröße berechnet wird.

6. Verfahren nach einem der Ansprüche 1 bis 5,
**dadurch gekennzeichnet,**
**daß** die Drehung des Testfensters (15) um ein Winkelinkrement und anschließende Berechnung der Varianz der Abweichungen so oft wiederholt wird, bis ein Gesamtdrehwinkel von 180° bezüglich der Ausgangslage des Testfensters (15) erreicht ist.

7. Verfahren nach einem der Ansprüche 1 bis 6,
**dadurch gekennzeichnet,**
**daß** die Varianz über dem jeweiligen Drehwinkel des Testfensters (15) zum Vergleich grafisch dargestellt wird.

8. Verfahren nach einem der Ansprüche 1 bis 7,
**dadurch gekennzeichnet,**
**daß** die Bezugsgröße durch Bilden des Mittelwerts oder einer Regressionsfunktion aus den Mittelwerten der Signale aller Segmente (18) eines Testfensters (15) bei ungestörtem Testbild (13) erzeugt wird.

9. Verfahren nach einem der Ansprüche 1 bis 8,
**dadurch gekennzeichnet,**
**daß** das Testbild (13) mehrere Farbbalken (16) aufweist und daß die Größe des Testfensters (15) so bestimmt ist, daß bei keinem Drehwinkel Bildpunkte eines benachbarten Farbbalkens (16) innerhalb des Testfensters (15) angeordnet sind.

10. Verfahren nach Anspruch 6,
**dadurch gekennzeichnet,**
**daß** die Position der Ausgangslage nach Erreichen der 180° Drehung um ein Längeninkrement parallel zu einer Farbbalkengrenze (17) verschoben wird.

11. Verfahren nach einem der Ansprüche 1 bis 10,
**dadurch gekennzeichnet,**
**daß** die Auswertung für mehrere Farbbalken (16) wiederholt wird.

12. Prüfvorrichtung zum Überprüfen der elektromagnetischen Verträglichkeit von Bildschirmgeräten, mit einem Prüfgenerator (7), der mit einem Prüfling (1) zur Übermittlung eines Testbild- und Störsignals verbindbar ist, und einer mit dem Prüfgenerator (7) verbindbaren Recheneinheit (8), die einen Eingang (8a) zum Einlesen einer Bildinformation aufweist, wobei die Recheneinheit (8) folgende Berechnungen durchführt:
- Unterteilen der Bildinformation eines Testfensters (15) in mehrere parallele Segmente (18);
- Ermitteln einer Bezugsgröße aus einem störungsfreien Testbild (13) in dem Testfenster (15);
- Bilden des Mittelwerts des Signals jedes Segments (18);
- Berechnen der Abweichung des Mittelwerts jedes einzelnen Segments (18) von der Bezugsgröße;
- Berechnen der Varianz der Abweichungen aller Segmente (18) des Testfensters (15);
- Wiederholen der Berechnung der Varianz der Abweichungen für mehrere, jeweils um ein Winkelinkrement gedrehte Testfenster (15); und
- Vergleichen der für die einzelnen Drehwinkel des Testfensters (15) berechneten Varianzen der Abweichungen.

13. Prüfvorrichtung nach Anspruch 12,
**dadurch gekennzeichnet,**
**daß** der Eingang (8a) der Recheneinheit (8) zum Einlesen der Bildinformation mit einer Camera (5) verbunden ist.

14. Prüfvorrichtung nach Anspruch 13,
**dadurch gekennzeichnet,**
**daß** der Prüfling (1) in einem reflexionsarmen Dunkelraum (2) angeordnet ist und daß zur Reduzierung des Blickwinkels in den Dunkelraum (2) ein Tubus (6) auf der Camera (5) angeordnet ist.

15. Prüfvorrichtung nach Anspruch 13 oder 14,
**dadurch gekennzeichnet,**
**daß** zur Überwachung des von der Camera (5) aufgenommenen Bilds ein Monitor (12) mit der Camera (5) verbunden ist.

16. Prüfvorrichtung nach einem der Ansprüche 13 bis 15,
**dadurch gekennzeichnet,**
**daß** eine stufenweise beeinflußbare Bildschärfe so einstellbar ist, daß der Einfluß von Bildfehlern, insbesondere Moirémustern, eines störungsfreien Testbilds (13) auf die Bezugsgröße minimal ist.

17. Prüfvorrichtung nach einem der Ansprüche 12 bis 16,
**dadurch gekennzeichnet,**
**daß** die Recheneinheit (8) ein Personal Computer ist, der einen FPGA und/oder DSP als Co-Prozessor aufweist.

## Claims

1. Method of testing the electromagnetic compatibility of viewing-screen devices that receive a signal for a test image from a test generator (7) that can additionally subject a device under test (1) to a test-image signal containing an interference signal, comprising the following method steps:
- division of the image information of a test window (15) into a plurality of parallel segments (18);
- determination of a reference variable from an interference-free test image (13) in the test window (15);
- formation of the mean value of the signal of every segment (18);
- calculation of the deviation of the mean value of every individual segment (18) from the reference variable;
- calculation of the variance of the deviations of all the segments (18) of the test window (15);
- repetition of the calculation of the variance of the deviations for a plurality of test windows (15) each rotated through an angular increment; and
- comparison of the variances of the deviations calculated for the individual rotational angles of the test window (15).

2. Method according to Claim 1, **characterized in that** the image information of the test image (13) is converted into a grey-value image.

3. Method according to Claim 1, **characterized in that** the method is performed for a sector (14) of the test image (13), within which sector the test window (15) is positioned.

4. Method according to Claim 3, **characterized in that** the image information of the sector (14) is converted into a grey-value image.

5. Method according to any of Claims 1 to 4, **characterized in that** the variance is calculated as the mean of the square deviation in the reference variable.

6. Method according to any of Claims 1 to 5, **characterized in that** the rotation of the test window (15) through an angular increment and subsequent calculation of the variance of the deviations is repeated until a total rotational angle of 180° with respect to the initial position of the test window (15) has been reached.

7. Method according to any of Claims 1 to 6, **characterized in that** the variance is shown against the respective rotational angle of the test window (15) graphically for the purpose of comparison.

8. Method according to any of Claims 1 to 7, **characterized in that** the reference variable is generated by forming the mean value or a regression function derived from the mean values of the signals of all the segments (18) of a test window (15) in the case of an undisturbed test image (13).

9. Method according to any of Claims 1 to 8, **characterized in that** the test image (13) has a plurality of colour bars (16) and **in that** the size of the test window (15) is determined in such a way that pixels of an adjacent colour bar (16) are not disposed within the test window (15) for any rotational angle.

10. Method according to Claim 6, **characterized in that** the location of the initial position after reaching a rotation of 180° is displaced by a length increment parallel to a colour bar boundary (17).

11. Method according to any of Claims 1 to 10,
**characterized in that** the evaluation is repeated for a plurality of colour bars (16).

12. Test device for checking the electromagnetic compatibility of viewing-screen devices, comprising a test generator (7) that can be connected to a device under test (1) for transmitting a test-image and interference signal, and a computer unit (8) that can be connected to the test generator (7) and that has an input (8a) for reading an image-information item in, wherein the computer unit (8) performs the following calculations:
- division of the image information of a test window (15) into a plurality of parallel segments (18);
- determination of a reference variable from an interference-free test image (13) in the test window (15);
- formation of the mean value of the signal of every segment (18);
- calculation of the deviation of the mean value of every individual segment (18) from the reference variable;
- calculation of the variance of the deviations of all the segments (18) of the test window (15);
- repetition of the calculation of the variance of the deviations for a plurality of test windows (15) each rotated through an angular increment; and
- comparison of the variances of the deviations calculated for the individual rotational angles of the test window (15).

13. Test device according to Claim 12, **characterized in that** the input (8a) of the computer unit (8) is connected to a camera (5) for the purpose of reading the image information in.

14. Test device according to Claim 13, **characterized in that** the device under test (1) is disposed in a low-reflection darkroom (2) and **in that** a tube (6) is disposed on the camera (5) for the purpose of reducing the viewing angle in the darkroom (2).

15. Test device according to Claim 13 or 14, **characterized in that** a monitor (12) is connected to the camera (5) for the purpose of monitoring the image recorded by the camera (5).

16. Test device according to any of Claims 13 to 15, **characterized in that** an image sharpness that can be influenced in steps is adjusted in such a way that the influence of image errors, in particular moiré patterns, of an interference-free test image (13) on the reference variable is minimal.

17. Test device according to any of Claims 12 to 16, **characterized in that** the computer unit (8) is a personal computer that has a FPGA and/or a DSP as coprocessor.

## Revendications

1. Procédé de contrôle de la compatibilité électromagnétique d'appareils à écran qui reçoivent un signal d'image de test venant d'un générateur de contrôle (7) au moyen duquel un signal parasite peut être appliqué à un spécimen à tester (1) en plus d'un signal d'image de test, comprenant les étapes de procédé suivantes:
- Partage des informations d'image d'une fenêtre de test (15) en plusieurs segments parallèles (18);
- Détermination d'une grandeur de référence à partir d'une image de test exempte de parasites (13) dans la fenêtre de test (15);
- Formation de la moyenne du signal de chaque segment (18);
- Calcul de l'écart entre la moyenne de chaque segment (18) individuel et la grandeur de référence;
- Calcul de la variance des écarts de tous les segments (18) de la fenêtre de test (15);
- Répétition du calcul de la variance des écarts pour plusieurs fenêtres de test (15) tournées respectivement d'un incrément d'angle; et
- Comparaison des variances des écarts calculées pour les différents angles de rotation de la fenêtre de test (15).

2. Procédé selon la revendication 1, **caractérisé en ce que** les informations d'image de l'image de test (13) sont converties en une image en niveaux de gris.

3. Procédé selon la revendication 1, **caractérisé en ce que** le procédé est effectué pour une portion (14) de l'image de test (13) à l'intérieur de laquelle la fenêtre de test (15) est positionnée.

4. Procédé selon la revendication 3, **caractérisé en ce que** les informations d'image de la portion (14) sont converties en une image en niveaux de gris.

5. Procédé selon l'une des revendications 1 à 4, **caractérisé en ce que** la variance est calculée sous la forme de la moyenne de l'écart quadratique par rapport à la valeur de référence.

6. Procédé selon l'une des revendications 1 à 5, **caractérisé en ce que** la rotation de la fenêtre de test (15) d'un incrément d'angle et le calcul de la variance des écarts effectué ensuite se répètent jusqu'à ce qu'un angle de rotation total de 180° par rapport à la position de départ de la fenêtre de test (15) soit atteint.

7. Procédé selon l'une des revendications 1 à 6, **caractérisé en ce que** la variance sur l'angle de rotation concerné de la fenêtre de test (15) est représentée graphiquement aux fins de comparaison.

8. Procédé selon l'une des revendications 1 à 7, **caractérisé en ce que** la grandeur de référence est obtenue par calcul de la moyenne ou par une fonction de régression à partir des moyennes des signaux de tous les segments (18) d'une fenêtre de test (15) pour une image de test (13) sans parasites.

9. Procédé selon l'une des revendications 1 à 8, **caractérisé en ce que** l'image de test (13) présente plusieurs barres colorées (16) et **en ce que** la taille de la fenêtre de test (15) est définie de telle façon que les points d'image d'une barre colorée (16) voisine ne soient disposés à l'intérieur de la fenêtre de test (15) pour aucun angle de rotation.

10. Procédé selon la revendication 6, **caractérisé en ce que** l'emplacement de la position de départ est décalé d'un incrément de longueur parallèlement à une limite de barre colorée (17) lorsque la rotation de 180° a été atteinte.

11. Procédé selon l'une des revendications 1 à 10, **caractérisé en ce que** la détermination est répétée pour plusieurs barres colorées (16).

12. Dispositif de test pour contrôler la compatibilité électromagnétique d'appareils à écran, comprenant un générateur de test (7) pouvant être relié à un spécimen à tester (1) pour transmettre un signal d'image et un signal parasite, et un module de calcul (8) pouvant être relié au générateur de test (7) et présentant une entrée (8a) pour recevoir des informations d'image, le module de calcul (8) effectuant les opérations suivantes:
- Partage des informations d'image d'une fenêtre de test (15) en plusieurs segments parallèles (18);
- Détermination d'une grandeur de référence à partir d'une image de test exempte de parasites (13) dans la fenêtre de test (15);
- Formation de la moyenne du signal de chaque segment (18);
- Calcul de l'écart entre la moyenne de chaque segment (18) individuel et la grandeur de référence;
- Calcul de la variance des écarts de tous les segments (18) de la fenêtre de test (15);
- Répétition du calcul de la variance des écarts pour plusieurs fenêtres de test (15) tournées respectivement d'un incrément d'angle; et
- Comparaison des variances des écarts calculées pour les différents angles de rotation de la fenêtre de test (15).

13. Dispositif de test selon la revendication 12, **caractérisé en ce que** l'entrée (8a) du module de calcul (8) destiné à recevoir les informations d'image est reliée à une caméra (5).

14. Dispositif de test selon la revendication 13, **caractérisé en ce que** le spécimen à tester (1) est disposé dans une chambre noire anéchoïque (2) et **en ce que**, pour réduire l'angle de vision dans la chambre noire (2), un tube (6) est disposé sur la caméra (5).

15. Dispositif de test selon la revendication 13 ou la revendication 14, **caractérisé en ce qu'**un moniteur (12) est relié à la caméra (5) pour contrôler l'image enregistrée par la caméra (5).

16. Dispositif de test selon l'une des revendications 13 à 15, **caractérisé en ce qu'**une définition d'image sur laquelle on peut agir par degrés est réglable de façon que l'influence des défauts d'image, en particulier des effets de moiré, d'une image de test (13) exempte de parasites sur la grandeur de référence soit minime.

17. Dispositif de test selon l'une des revendications 12 à 16, **caractérisé en ce que** le module de calcul (8) est un ordinateur personnel présentant un circuit FPGA et/ou un processeur DSP en tant que coprocesseur.
